# EUROPÄISCHE PATENTSCHRIFT

(11) **EP 0 698 964 B1**
(45) Veröffentlichungstag und Bekanntmachung des Hinweises auf die Patenterteilung: **17.03.1999**
(21) Anmeldenummer: 95112136.7
(22) Anmeldetag: 02.08.1995
(51) Int. Cl.: H03D 7/14

(54) **HF-Mischstufe**
RF mixer stage
Mélangeur haute fréquence

(30) Priorität: 26.08.1994 DE 4430314
(43) Veröffentlichungstag der Anmeldung: 28.02.1996
(73) Patentinhaber: TEMIC Semiconductor GmbH, 74072 Heilbronn (DE)
(72) Erfinder: Rinderle, Heinz, D-74080 Heilbronn (DE); Sapotta, Hans, Dr., D-74078 Heilbronn (DE)
(74) Vertreter: Maute, Hans-Jürgen, Dipl.-Ing.

(56) Entgegenhaltungen:
- EP-A- 0 565 299
- EP-A- 0 631 379
- DE-A- 4 206 164
- US-A- 4 032 851
- US-A- 4 080 573
- US-A- 4 090 139
- US-A- 4 978 873
- US-A- 5 039 891

## Beschreibung

Mischstufen werden in der Schaltungstechnik häufig eingesetzt, insbesondere zur Umsetzung der Frequenz eines Eingangssignals in einen anderen Frequenzbereich; ein Hauptanwendungsfall hierzu ist in der Rundfunktechnik die Erzeugung der Zwischen-Frequenz (die beispielsweise in superheterodynamischen Empfängerstufen benötigt wird) aus dem HF-Eingangssignal. HF-Mischstufen werden entweder als additive Mischstufen - hier wird das Eingangssignal zusammen mit einem Oszillatorsignal (LO-Signal) auf eine nicht-lineare Kennlinie gegeben und durch die Nicht-Linearität eine Vielzahl von Mischprodukten erzeugt - oder als multiplikative Mischstufen ausgebildet - hier wird durch eine kombinierte Schaltung aus Verstärkertransistoren und Schalttransistoren eine echte Signalmultiplikation vorgenommen. Obwohl bei multiplikativen Mischstufen nur sehr wenig unerwünschte Mischprodukte entstehen, sind wegen deren technisch sehr aufwendigen und damit auch kostspieligen Realisierung in vielen Frequenzbereichen additive Mischstufen gebräuchlich.

Additive Mischstufen bestehen in der Regel aus einem Bipolartransistor als Mischtransistor, der in Emitterschaltung oder Basisschaltung betrieben wird; das LO-Signal kann entweder dem Emitter oder der Basis zugeführt werden, wobei für letzteren Fall eine geringere Leistung des Oszillators erforderlich ist (eine hohe Oszillatorleistung ist mit erhöhtem Strombedarf und technischem Aufwand verbunden). Der durch das LO-Signal gesteuerte Mischtransistor ist entweder aktiv oder gesperrt; da der Lastwiderstand konstant ist, ergibt sich eine Verstärkung des LO-Signals am Kollektor. Nachteilig hierbei ist, daß
- das Rauschen der additiven Mischstufe höher und gleichzeitig das Großsignalverhalten schlechter als bei einer Verstärkerstufe ist, so daß additive Mischstufen nur eine geringe Dynamik aufweisen und damit das schwächste Glied innerhalb einer Signal-Übertragungskette darstellen
- bei einer breitbandigen Auskopplung des Ausgangssignals aus der Mischstufe aufgrund der zahlreichen unerwünschten Mischprodukte und Oberwellen Störsignale erzeugt werden
- das LO-Signal auf den Eingang der Mischstufe übertragen wird; dies kann beispielsweise bei RF-Empfängern dazu führen, daß das LO-Signal über die Antenne als Störsignal abgestrahlt wird.

Andere Mischerschaltungen, insbesondere Gegentakt-Mischer, sind aus DE-A-4 206 164 bekannt.

Der Erfindung liegt die Aufgabe zugrunde, eine HF-Mischstufe mit vorteilhaften Eigenschaften anzugeben. Diese Aufgabe wird erfindungsgemäß durch die Merkmale im Kennzeichen des Patentanspruchs 1 gelöst. Vorteilhafte Weiterbildungen der Erfindung ergeben sich aus den Unteransprüchen.

Die vorgestellte HF-Mischstufe ist als additive Gegentakt-Mischstufe ausgebildet und weist dazu zwei komplementäre in Basisschaltung bzw. Gateschaltung betriebene Transistoren auf; die Transistoren sind so angeordnet, daß im Signalzweig dem Transistor einer Polarität der Transistor der anderen Polarität für Wechselspannungs-Eingangssignale parallel geschaltet ist. Falls der Gleichstrom durch beide Transistoren identisch ist - dies ist durch eine gleichstrommäßige Serienschaltung am einfachsten realisierbar - kompensieren sich die Intermodulationsprodukte der beiden Transistoren. Die vorgestellte HF-Mischstufe vereinigt mehrere Vorteile in sich:
- durch die Kompensation der Intermodulationsprodukte ist eine erhebliche Steigerung der Linearität und damit der Dynamik der Mischstufe erreichbar,
- da der von einem der beiden Transistoren an der Kollektor- bzw. Drain-Elektrode gelieferte L0-Strom vom komplementären Transistor wieder "abgesaugt" wird, treten an den Kollektoren bzw. Drains keine oder nur stark abgeschwächte L0-Komponenten auf; es findet somit eine Unterdrückung der LO-Anteile am Ausgang der Mischstufe statt,
- da das Oszillatorsignal in Gegentakt an den Basen bzw. Gates der parallel geschalteten Transistoren anliegt, ist es am Eingang der Mischstufe unterdrückt, so daß eine Ausstrahlung des LO-Signals (beispielsweise über die Antenne) verringert wird.

Das LO-Signal muß zur Ansteuerung der komplementären Transistoren an deren Steuerelektrode mit einer Phasenverschiebung von 180° vorliegen; dies kann entweder unter Verwendung von Symmetrierübertragern oder unter Verwendung elektronischer Maßnahmen realisiert werden.

Anhand der Zeichnung mit den Figuren 1 bis 4 wird die HF-Mischstufe für den Fall bipolarer Transistoren näher erläutert. Dabei zeigen die Figuren 1 und 2 Ausführungsbeispiele, bei denen die Emitter der beiden in Basisschaltung betriebenen Transistoren miteinander verbunden sind; die Figuren 3 und 4 zeigen Ausführungsbeispiele, bei denen die Kollektoren der beiden in Basisschaltung betriebenen Transistoren miteinander verbunden sind.

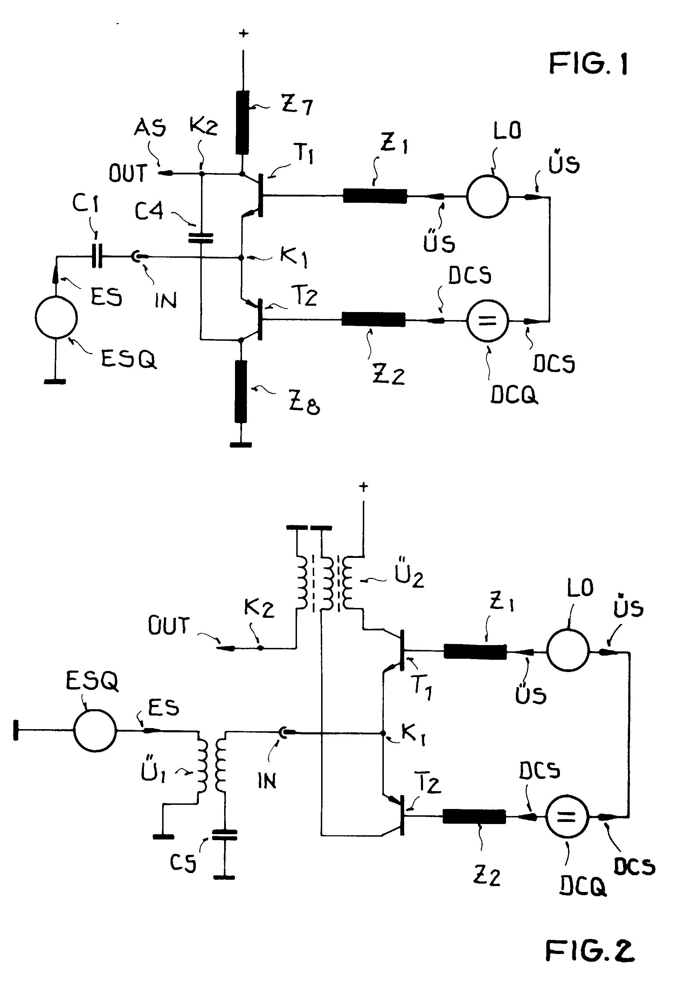

Bei den Schaltungsbeispielen der Fig. 1 und 2 sind die Emitter der beiden bipolaren Transistoren T₁ und T₂ an einem Knotenpunkt K₁ miteinander verbunden.

### Einkopplung des Eingangssignals:

Gemäß der Figur 1 wird das von der Eingangssignalquelle ESQ gelieferte Wechselspannungs-Eingangssignal ES über den Kondensator C₁ kapazitiv am Schaltungseingang IN auf die am Knotenpunkt K₁ miteinander verbundenen Emitter der beiden Transistoren T₁ und T₂ eingekoppelt. Gemäß der Figur 2 wird das von der Eingangssignalquelle ESQ gelieferte Wechselspannungs-Eingangssignal ES induktiv über den Ubertrager Ü₁ am Schaltungseingang IN auf die am Knotenpunkt K₁ miteinander verbundenen Emitter der beiden Transistoren T₁ und T₂ eingekoppelt; ein Anschluß der mit dem Schaltungseingang IN verbundenen Sekundärwicklung des Übertragers Ü₁ ist über den Kondensator C₅ an Bezugspotential angeschlossen.

### Basisansteuerung:

Die Basen der beiden Transistoren T₁ und T₂ sind über frequenzabhängige Impedanzen Z₁ und Z₂ mit dem das Uberlagerungssignal US liefernden Lokaloszillator LO und der das Gleichspannungssignal DCS liefernden Gleichspannungsquelle DCQ verbunden. Die Impedanzen Z₁ und Z₂ werden so gewählt, daß sie für das gewünschte Mischprodukt (beispielsweise f₁ - f₂, wobei f₁ die Frequenz des Eingangssignals ES und f₂ die Frequenz des Uberlagerungssignals ÜS ist) niederohmig sind; hierdurch wird erreicht, daß die an den Emittern der Transistoren T₁ und T₂ entstehenden Differenzfrequenzsignale verlustfrei und rauscharm in das Ausgangssignal AS überführt werden. Das Gleichspannungssignal DCS der Gleichspannungsquelle DCQ wird so gewählt, daß ein Durchschalten der beiden Transistoren T₁ und T₂ im Verlauf einer Periode des Überlagerungssignals ÜS des Lokaloszillator LO einmal ermöglicht wird.

### Auskopplung:

Gemäß der Figur 1 wird das Ausgangssignal AS am Schaltungsausgang OUT an den über den Kondensator C₄ am Summationspunkt K₂ verbundenen Kollektoren der beiden Transistoren T₁ und T₂ abgenommen. Die Kollektoren des Transistors T₁ bzw. des Transistors T₂ sind über frequenzabhängige Impedanzen Z₇ bzw. Z₈ mit dem positiven bzw. negativen Anschluß der Versorgungs-Gleichspannung verbunden. Die Impedanz Z₇ wird so gewählt, daß sie für das gewünschte Mischprodukt (beispielsweise f₁ - f₂) hochohmig und für alle anderen Frequenzen (einschließlich der Frequenz f = 0) niederohmig ist; hierdurch wird das gewünschte Ausgangssignal AS (Frequenz f₁ - f₂) selektiv verstärkt. Die Impedanz Z₈ wird so gewählt, daß sie für das gewünschte Mischprodukt hochohmig ist und mindestens für die Frequenz f = 0 niederohmig ist. Die Impedanzen Z₇ und Z₈ und somit deren Wirkungsweisen sind vertauschbar.

Gemäß der Figur 2 wird das Ausgangssignal AS am Schaltungsausgang OUT über den trifilaren Ubertrager Ü₂ abgenommen, dessen erste Wicklung mit dem Kollektor des Transistors T₁ und dem positiven Anschluß der Versorgungs-Gleichspannung, dessen zweite Wicklung mit dem Kollektor des Transistors T₂ und dem negativen Anschluß der Versorgungs-Gleichspannung und dessen dritte Wicklung mit dem Schaltungsausgang OUT und dem negativen Anschluß der Versorgungs-Gleichspannung verbunden ist.

Die Impedanzen Z₁, Z₂, Z₇ und Z₈ können passiv oder elektronisch aktiv realisiert werden, beispielsweise als Widerstände, Kondensatoren, Spulen oder als Transistoren, Transistorschaltungen etc.

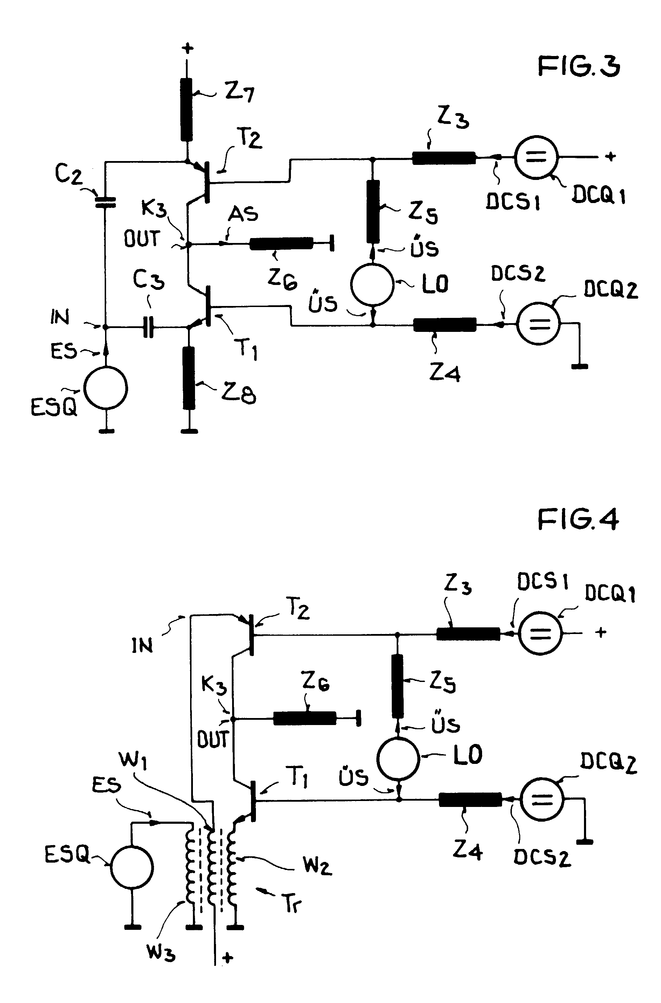

In den Schaltungsbeispielen der Figuren 3 und 4 sind die Kollektoren der beiden bipolaren Transistoren T₁ und T₂ an einem Ausgangsknotenpunkt K₃ miteinander verbunden.

### Einkopplung des Eingangssignals:

Gemäß der Figur 3 wird das von der Eingangssignalquelle ESQ gelieferte Eingangssignal ES kapazitiv über die beiden mit dem Schaltungseingang IN und den Emittern der beiden Transistoren T₁ bzw. T₂ verbundenen Kondensatoren C₂ und C₃ eingekoppelt. Die Emitter der beiden Transistoren T₁ bzw. T₂ sind dabei über frequenzabhängige Impedanzen Z₈ bzw. Z₇ an den negativen bzw. positiven Anschluß der Versorgungs-Gleichspannung angeschlossen; die Impedanzen Z₇ und Z₈ werden so gewählt, daß die Parallelschaltung von Z₇ und C₂ bzw. Z₈ und C₃ für das gewünschte Mischprodukt niederohmig wird und die Impedanzen Z₈ bzw. Z₇ für die Frequenz f = 0 niederohmig werden.

Gemäß der Figur 4 wird das von der Eingangssignalquelle ESQ gelieferte Eingangssignal ES über den Transformator Tr mit den drei Wicklungen W₁, W₂ und W₃ induktiv auf die Emitter der beiden Transistoren T₁ und T₂ eingekoppelt. Die erste Wicklung W₁ des Transformators Tr ist mit einem Anschluß an den positiven Anschluß der Versorgungs-Gleichspannung und mit dem anderen Anschluß an den Emitter des Transistors T₂ angeschlossen, die zweite Wicklung W₂ des Transformators Tr ist mit einem Anschluß an den negativen Anschluß der Versorgung-Gleichspannung und mit dem anderen Anschluß an den Emitter des Transistors T₁ angeschlossen, die dritte Wicklung des Transformators Tr ist mit einem Anschluß an den negativen Anschluß der Versorgungs-Gleichspannung und mit dem anderen Anschluß mit der Eingangssignalquelle ESQ verbunden.

### Auskopplung:

Das Ausgangssignal AS wird an dem den Schaltungsausgang OUT bildenden Ausgangsknotenpunkt K₃ (hier sind die beiden Kollektoren der Transistoren T₁ und T₂ miteinander verbunden) über die frequenzanhängige Impedanz Z₆ ausgekoppelt. Die Impedanz Z₆ wird so gewählt, daß sie für das gewünschte Mischprodukt hochohmig ist und für alle anderen Frequenzen möglichst niederohmig wird sowie für die Frequenz f = 0 möglichst unendlich wird; hierdurch wird das gewünschte Ausgangssignal AS (Mischprodukt) selektiv verstärkt.

### Basisansteuerung:

Die Basen der beiden Transistoren T₁ und T₂ sind über die frequenzabhängigen Impedanzen Z₃ und Z₄ mit den die Gleichspannungssignale DCS1 und DCS2 liefernden Gleichspannungsquellen DCQ1 und DCQ2 verbunden sowie über die frequenzabhängige Impedanz Z₅ an den das Überlagerungssignal ÜS liefernden Lokaloszillator LO angeschlossen. Die Impedanzen Z₃ und Z₄ werden so gewählt, daß sie für das gewünschte Mischprodukt, die Frequenz f = 0 und die gewünschte Mischfrequenz (beispielsweise f₁ - f₂) niederohmig und für die Frequenz des Uberlagerungssignals ÜS hochohmig sind; hierdurch wird erreicht, daß das Uberlagerungssignal nicht über die Gleichspannungsquellen DCQ1 bzw. DCQ2 kurzgeschlossen wird und die an den Emittern der Transistoren T₁, T₂ entstehenden Mischprodukte rauscharm und verlustfrei in das Ausgangssignal AS überführt werden. Die Impedanz Z₅ wird so gewählt, daß sie für die Frequenz des Uberlagerungssignals ÜS niederohmig und für die Frequenz f = 0 sehr hochohmig wird. Die Gleichspannungssignale DCS1 und DCS2 der beiden Gleichspannungsquellen DCQ1 und DCQ2 werden so gewählt, daß am Kollektoranschluß der beiden Transistoren T₁ bzw. T₂ ohne Uberlagerungssignal US ungefähr die halbe Versorgungs-Gleichspannung ansteht. Die Impedanzen Z₃ bis Z₈ können passiv (Widerstände, Kondensatoren, Spulen etc.) oder elektronisch aktiv (Transistoren etc.) realisiert werden.

## Patentansprüche

1. HF-Mischstufe zur Frequenzumsetzung eines am Schaltungseingang (IN) anstehenden Wechselspannungs-Eingangssignals (ES) in ein am Schaltungsausgang (OUT) ausgegebenes Ausgangssignal (AS), mit
- einer Eingangs-Signalquelle (ESQ) zur Generierung des Wechselspannungs-Eingangssignals (ES),
- einem Lokal-Oszillator (LO) zur Bereitstellung eines Überlagerungssignal (ÜS) und
- zwei für das Wechselspannungs-Eingangssignal (ES) parallelgeschalteten komplementären Transistoren (T₁, T₂) in Basisschaltung bzw. Gateschaltung,
dadurch gekennzeichnet, daß
die beiden Transistoren (T₁, T₂) basisseitig bzw. gateseitig derart mit dem Lokal-Oszillator (LO) verbunden sind, daß sie durch das Überlagerungssignal (ÜS) gegensinnig angesteuert werden und im Takt des Überlagerungssignals (ÜS) beide gleichzeitig und gleichsinnig zwischen leitendem und sperrendem Zustand wechseln.

2. Mischstufe nach Anspruch 1, dadurch gekennzeichnet, daß die beiden Transistoren (T₁, T₂) für die Versorgungs-Gleichspannung in Serie geschaltet sind.

3. Mischstufe nach Anspruch 1 oder 2, dadurch gekennzeichnet, daß das Wechselspannungs-Eingangssignal (ES) parallel den Emitter- bzw. Source-Elektroden der beiden Transistoren (T₁, T₂) zugeführt wird, und daß das Ausgangssignal (AS) parallel von den Kollektor- bzw. Drain-Elektroden der beiden Transistoren (T₁, T₂) abgenommen wird.

4. Mischstufe nach einem der Ansprüche 1 bis 3, dadurch gekennzeichnet, daß das Wechselspannungs-Eingangssignal (ES) den Emitter- bzw. Source-Elektroden der beiden Transistoren (T₁, T₂) über Schaltungsmittel (C₁, C₂, C₃, Ü₁, Tr) durch kapazitive oder induktive Einkopplung zugeführt wird.

5. Mischstufe nach einem der Ansprüche 1 bis 4, dadurch gekennzeichnet, daß das Überlagerungssignal (ÜS) gleichzeitig mit einem Gleichspannungssignal (DCQ, DCQ1, DCQ2) über Schaltungsmittel (Z₁, Z₂, Z₃, Z₄, Z₅) zur Arbeitspunkteinstellung den Basis-Elektroden der beiden Transistoren (T₁, T₂) zugeführt wird.

6. Mischstufe nach einem der Ansprüche 1 bis 5, dadurch gekennzeichnet, daß der Schaltungsausgang (OUT) durch einen Summationspunkt bzw. Ausgangsknotenpunkt (K₂ bzw. K₃) gebildet wird, an dem die aus den Kollektor-bzw. Drain-Elektroden der beiden Transistoren (T₁, T₂) herausfließenden Wechselströme summiert werden, und daß das Ausgangssignal (AS) über Schaltungsmittel (C₄, Ü₂ bzw. Z₆) abgenommen wird.

7. Mischstufe nach einem der Ansprüche 1 bis 6, dadurch gekennzeichnet, daß die Emitter-Elektroden bzw. Source-Elektroden der beiden Transistoren (T₁, T₂) an einem Knotenpunkt (K₁) miteinander verbunden sind.

8. Mischstufe nach Anspruch 7, dadurch gekennzeichnet, daß das Wechselspannungs-Eingangssignal (ES) den am Knotenpunkt (K₁) miteinander verbundenen Emitter- bzw. Source-Elektroden der beiden Transistoren (T₁, T₂) über einen Kondensator (C₁) zugeführt wird.

9. Mischstufe nach Anspruch 7, dadurch gekennzeichnet, daß das Wechselspannungs-Eingangssignal (ES) den am Knotenpunkt (K₁) miteinander verbundenen Emitter- bzw. Source-Elektroden der beiden Transistoren (T₁, T₂) über einen ersten Übertrager (Ü₁) zugeführt wird.

10. Mischstufe nach einem der Ansprüche 7 bis 9, dadurch gekennzeichnet, daß die Kollektor-Elektroden der beiden Transistoren (T₁ bzw. T₂) über frequenzabhängige Impedanzen (Z₇, bzw. Z₈) an die Versorgungsspannung bzw. an Bezugspotential angeschlossen sind.

11. Mischstufe nach einen der Ansprüche 7 bis 10, dadurch gekennzeichnet, daß das Ausgangssignal (AS) an einem Summationspunkt (K₂) abgenommen wird, an dem die Kollektor-Elektroden der beiden Transistoren (T₁, T₂) über einen Kondensator (C₄) miteinander verbunden sind.

12. Mischstufe nach einem der Ansprüche 7 bis 10, dadurch gekennzeichnet, daß das Ausgangssignal (AS) an einem Summationspunkt (K₂) abgenommen wird, an dem die dritte Wicklung eines die Kollektor-Elektroden der beiden Transistoren (T₁, T₂) miteinander verbindenden zweiten Übertragers (Ü₂) angeschlossen ist.

13. Mischstufe nach einem der Ansprüche 7 bis 12, dadurch gekennzeichnet, daß die Basis- bzw. Gate-Elektroden der beiden Transistoren (T₁, T₂) über frequenzabhängige Impedanzen (Z₁, Z₂) mit dem Lokal-Oszillator (LO) und einer Gleichspannungsquelle (DCQ) zur Bereitstellung des Gleichspannungssignals (DCS) verbunden sind.

14. Mischstufe nach einem der Ansprüche 1 bis 6, dadurch gekennzeichnet, daß die Kollektor- bzw. Drain-Elektroden der beiden Transistoren (T₁, T₂) an einem Ausgangsknotenpunkt (K₃) miteinander verbunden sind.

15. Mischstufe nach Anspruch 14, dadurch gekennzeichnet, das am Schaltungseingang (IN) anliegende Wechselspannungs-Eingangssignal (ES) den Emitter- bzw. Source-Elektroden der beiden Transistoren (T₁, T₂) über Schaltungsmittel (C₂, C₃) zur DC-Abtrennung parallel zugeführt wird.

16. Mischstufe nach Anspruch 15, dadurch gekennzeichnet, daß die Emitter-bzw. Source-Elektrode des ersten Transistors (T₁) zur DC-Versorgung und AC-Abtrennung über eine frequenzabhängige Impedanz (Z₈) mit dem negativen Anschluß der Versorgungs-Gleichspannung verbunden ist.

17. Mischstufe nach Anspruch 15 oder 16, dadurch gekennzeichnet, daß die Emitter- bzw. Source-Elektrode des zweiten Transistors (T₂) zur DC-Versorgung und AC-Abtrennung über eine frequenzabhängige Impedanz (Z₇) mit dem positiven Anschluß (+) der Versorgungs-Gleichspannung verbunden ist.

18. Mischstufe nach Anspruch 14, dadurch gekennzeichnet, daß zur Einkopplung des Eingangssignals (ES) ein Transformator (Tr) mit 3 Wicklungen vorgesehen ist, daß die erste Wicklung (W₁) des Transformators (Tr) an einem Pol mit der Emitter-Elektrode des zweiten Transistors (T₂) und am anderen Pol mit dem positiven Anschluß (+) der Versorgungs-Gleichspannung verbunden ist, daß die zweite Wicklung (W₂) des Transformators (Tr) an einem Pol mit der Emitter-Elektrode des ersten Transistors (T₁) und am anderen Pol mit dem negativen Anschluß der Versorgungs-Gleichspannung verbunden ist, und daß die dritte Wicklung (W₃) des Transformators (Tr) mit einem Pol an die Eingangs-Signalquelle (ESQ) angeschlossen ist.

19. Mischstufe nach einem der Ansprüche 14 bis 18, dadurch gekennzeichnet, daß das Ausgangssignal (AS) am Ausgangsknotenpunkt (K₃) über eine frequenzabhängige Impedanz (Z₆) abgenommen wird.

20. Mischstufe nach einem der Ansprüche 14 bis 19, dadurch gekennzeichnet, daß die Basis- bzw. Gate-Elektroden der beiden Transistoren (T₁, T₂) zur Unterdrückung der Frequenz des Wechselspannungs-Eingangssignals (ES) mit frequenzabhängigen Impedanzen (Z₃, Z₄, Z₅) und zur Spannungsversorgung mit dem Lokal-Oszillator (LO) und jeweils einer Gleichspannungsquelle (DCQ1, DCQ2) verbunden sind.

21. Mischstufe nach einem der Ansprüche 10 bis 20, dadurch gekennzeichnet, daß die frequenzabhängigen Impedanzen (Z₁-Z₈) als passive oder elektronisch aktive Bauelemente ausgebildet sind.

## Claims

1. A HF mixing stage for the frequency conversion of an a.c. voltage input signal (ES) occurring at the circuit input (IN) into an output signal (AS) supplied at the circuit output (OUT) comprising
- an input signal source (ESQ) for generating the a.c. voltage input signal (ES),
- a local oscillator (LO) for making available a superimposed signal (ÜS) and
- two complementary transistors (T₁, T₂), connected in parallel for the a.c. voltage input signal (ES), with a common base or gate connection,
characterised in that the two transistors (T₁, T₂) are connected by their base or gate to the local oscillator (LO) such that they are driven in opposing manner by the superimposed signal (ÜS) and in time with the superimposed signal (ÜS) both change simultaneously and in like manner between the conductive and the blocking state.

2. A mixing stage according to Claim 1, characterised in that the two transistors (T₁, T₂) are connected in series for the supply d.c. voltage.

3. A mixing stage according to Claim 1 or 2, characterised in that the a.c. voltage input signal (ES) is fed in parallel to the emitter or source electrodes of the two transistors (T₁, T₂) and that the output signal (AS) is tapped in parallel from the collector or drain electrodes of the two transistors (T₁, T₂).

4. A mixing stage according to one of Claims 1 to 3, characterised in that the a.c. voltage input signal (ES) is fed to the emitter or source electrodes of the two transistors (T₁, T₂) via circuit means (C₁, C₂, C₃, Ü₁, Tr) by capacitive or inductive input-coupling.

5. A mixing stage according to one of Claims 1 to 4, characterised in that the superimposed signal (ÜS) is fed to the base electrodes of the two transistors (T₁, T₂) at the same time as a d.c. voltage signal (DCQ, DCQ1, DCQ2) via circuit means (Z₁, Z₂, Z₃, Z₄, Z₅) for adjusting the operating point.

6. A mixing stage according to one of Claims 1 to 5, characterised in that the circuit output (OUT) is formed by a summation point or output node (K₂ or K₃) at which the alternating currents flowing out of the collector or drain electrodes of the two transistors (T₁, T₂) are added, and that the output signal (AS) is tapped via circuit means (C₄, Ü₂ or Z₆).

7. A mixing stage according to one of Claims 1 to 6, characterised in that the emitter electrodes or source electrodes of the two transistors (T₁, T₂) are connected to one another at a node (K₁).

8. A mixing stage according to Claim 7, characterised in that the a.c. voltage input signal (ES) is fed via a capacitor (C₁) to the emitter or source electrodes of the two transistors (T₁, T₂) connected to one another at the node (K₁).

9. A mixing stage according to Claim 7, characterised in that the a.c. voltage input signal (ES) is fed via a first transformer (Ü₁) to the emitter or source electrodes of the two transistors (T₁, T₂) connected to one another at the node (K₁).

10. A mixing stage according to one of Claims 7 to 9, characterised in that the collector electrodes of the two transistors (T₁ and T₂) are connected via frequency-dependent impedances (Z₇ and Z₈) to the supply voltage or reference potential.

11. A mixing stage according to one of Claims 7 to 10, characterised in that the output signal (AS) is tapped at a summation point (K₂) at which the collector electrodes of the two transistors (T₁, T₂) are connected to one another via a capacitor (C₄).

12. A mixing stage according to one of Claims 7 to 10, characterised in that the output signal (AS) is tapped at a summation point (K₂) connected to the third winding of a second transformer (Ü₂) interconnecting the collector electrodes of the two transistors (T₁, T₂).

13. A mixing stage according to one of Claims 7 to 12, characterised in that the base or gate electrodes of the two transistors (T₁, T₂) are connected via frequency-dependent impedances (Z₁, Z₂) to the local oscillator (LO) and to a d.c. voltage source (DCQ) for the provision of the d.c. voltage signal (DCS).

14. A mixing stage according to one of Claims 1 to 6, characterised in that the collector or drain electrodes of the two transistors (T₁, T₂) are connected to one another at an output node (K₃).

15. A mixing stage according to Claim 14, characterised in that the a.c. voltage input signal (ES) occurring at the circuit input (IN) is fed in parallel to the emitter or source electrodes of the two transistors (T₁, T₂) via circuit means (C₂, C₃) for the d.c. isolation.

16. A mixing stage according to Claim 15, characterised in that for the d.c. supply and a.c. isolation the emitter or source electrode of the first transistor (T₁) is connected via a frequency-dependent impedance (Z₈) to the negative terminal of the supply d.c. voltage.

17. A mixing stage according to Claim 15 or 16, characterised in that for the d.c. supply and a.c. isolation the emitter or source electrode of the second transistor (T₂) is connected via a frequency-dependent impedance (Z₇) to the positive terminal (+) of the supply d.c. voltage.

18. A mixing stage according to Claim 14, characterised in that for the input-coupling of the input signal (ES) a transformer (Tr) with three windings is provided, that the first winding (W₁) of the transformer (Tr) is connected by one pole to the emitter electrode of the second transistor (T₂) and is connected by the other pole to the positive terminal (+) of the supply d.c. voltage, that the second winding (W₂) of the transformer (Tr) is connected by one pole to the emitter electrode of the first transistor (T₁) and by the other pole to the negative terminal of the supply d.c. voltage, and that the third winding (W₃) of the transformer (Tr) is connected by one pole to the input signal source (ESQ).

19. A mixing stage according to one of Claims 14 to 18, characterised in that the output signal (AS) is tapped at the output node (K₃) via a frequency-dependent impedance (Z₆).

20. A mixing stage according to one of Claims 14 to 19, characterised in that for the suppression of the frequency of the a.c. voltage input signal (ES) the base or gate electrodes of the two transistors (T₁, T₂) are connected to frequency-dependent impedances (Z₃, Z₄, Z₅) and for the voltage supply they are connected to the local oscillator (LO) and to a respective d.c. voltage source (DCQ1, DCQ2).

21. A mixing stage according to one of Claims 10 to 20, characterised in that the frequency-dependent impedances (Z₁-Z₈) have the form of passive or electronically active components.

## Revendications

1. Etage mélangeur HF pour la conversion de fréquence d'un signal d'entrée de tension alternative (ES), apparaissant à l'entrée du circuit (IN), en un signal de sortie (AS) émis à la sortie du circuit (OUT), comportant
- une source de signal d'entrée (ESQ) pour générer le signal d'entrée de tension alternative (ES),
- un oscillateur local (LO) pour mettre à disposition un signal de superposition (ÜS) et
- deux transistors complémentaires, (T₁ et T₂), montés en parallèle pour le signal d'entrée de tension alternative (ES), en montage base commune ou en montage grille commune
caractérisé par le fait que
les deux transistors (T₁ et T₂), sont reliés, en montage base commune ou en montage grille commune à l'oscillateur local (LO), de façon qu'ils soient commandés en sens contraire par le signal de superposition (ÜS) et qu'au rythme du signal de superposition (ÜS), ils changent tous les deux, simultanément et dans le même sens, pour passer de l'état conducteur à l'état bloqué.

2. Étage mélangeur selon la revendication 1, caractérisé par le fait que les deux transistors (T₁ et T₂) pour la tension continue d'alimentation sont montés en série.

3. Étage mélangeur selon la revendication 1 ou 2, caractérisé par le fait que le signal d'entrée de tension alternative (ES) est amené en parallèle aux électrodes d'émetteur ou de source des deux transistors (T₁ et T₂) et que le signal de sortie (ES) est prélevé en parallèle aux électrodes de collecteur ou de drain des deux transistors (T₁ et T₂).

4. Étage mélangeur selon l'une des revendications 1 ou 2, caractérisé par le fait que le signal d'entrée de tension alternative (ES) est amené en parallèle aux électrodes d'émetteur ou de source des deux transistors (T₁ et T₂) par l'intermédiaire de moyens de commutation (C₁, C₂, C₃, Ü₁, Tr) par couplage capacitif ou inductif.

5. Étage mélangeur selon l'une des revendications 1 à 4, caractérisé par le fait que le signal de superposition (ÜS) est amené, en même temps qu'un signal de tension continue (DCQ, DCQ1, DCQ2) par l'intermédiaire de moyens de commutation (Z₁, Z₂, Z₃, Z₄, Z₅) pour le réglage du point de travail, aux électrodes de base des deux transistors (T₁ et T₂).

6. Étage mélangeur selon l'une des revendications 1 à 5, caractérisé par le fait que la sortie du circuit (OUT) est formée par un point de sommation ou par un point nodal de sortie (K₂ ou K₃) où sont additionnés les courants alternatifs qui proviennent des électrodes de collecteur ou de drain des deux transistors (T₁ et T₂) et que le signal de sortie (ES) est prélevé par l'intermédiaire de moyens de commutation (C₄, ÜS ou Z₆).

7. Étage mélangeur selon l'une des revendications 1 à 6, caractérisé par le fait que les électrodes d'émetteur ou les électrodes de source des deux transistors (T₁ et T₂) sont reliées ensemble en un point nodal (K₁).

8. Étage mélangeur selon la revendication 7, caractérisé par le fait que le signal d'entrée de tension alternative (ES) est amené aux électrodes d'émetteur ou de source, reliées l'une à l'autre au point nodal (K₁) des deux transistors (T₁ et T₂), par l'intermédiaire d'un condensateur (C₁).

9. Étage mélangeur selon la revendication 7, caractérisé par le fait que le signal d'entrée de tension alternative (ES) est amené aux électrodes d'émetteur ou de source, reliées l'une à l'autre au point nodal (K₁) des deux transistors (T₁ et T₂), par l'intermédiaire d'un premier transformateur (Ü₁).

10. Étage mélangeur selon l'une des revendications 7 à 9, caractérisé par le fait que les électrodes de collecteur des deux transistors (T₁ et T₂) sont reliées, par l'intermédiaire d'impédances, fonctions de la fréquence, (Z₇ ou Z₈), à la tension d'alimentation ou au potentiel de référence.

11. Étage mélangeur selon l'une des revendications 7 à 10, caractérisé par le fait que le signal de sortie (AS) est prélevé en un point de sommation (K₂) où les électrodes de collecteur des deux transistors (T₁ et T₂) sont reliées l'une à l'autre par l'intermédiaire d'un condensateur (C₄).

12. Étage mélangeur selon l'une des revendications 7 à 10, caractérisé par le fait que le signal de sortie (AS) est prélevé en un point de sommation (K₂) où est relié le troisième bobinage d'un second transformateur (Ü₂) qui relie l'une à l'autre les électrodes de collecteur des deux transistors T₁, T₂).

13. Étage mélangeur selon l'une des revendications 7 à 12, caractérisé par le fait que les électrodes de base ou de grille des deux transistors (T₁ et T₂) sont reliées, par l'intermédiaire d'impédances, fonction de la fréquence, (Z₁, Z₂), à l'oscillateur local (LO) et à une source de tension continue (DCQ) pour mise à disposition du signal de tension continue (DCS).

14. Étage mélangeur selon l'une des revendications 1 à 6, caractérisé par le fait que les électrodes de collecteur ou de drain des deux transistors (T₁ et T₂) sont reliées l'une à l'autre en point nodal de sortie (K₃).

15. Étage mélangeur selon la revendication 14, caractérisé par le fait que le signal d'entrée de tension alternative (ES) qui se trouve à la l'entrée du circuit (IN) est amené en parallèle aux électrodes d'émetteur ou de source des deux transistors (T₁ et T₂), par l'intermédiaire de moyens de commutation (C₂, C₃), en vue d'une séparation d'avec le courant continu.

16. Étage mélangeur selon la revendication 15, caractérisé par le fait qu'en vue de l'alimentation en courant continu et d'une séparation d'avec le courant alternatif, l'électrode d'émetteur ou l'électrode de source du premier transistor (T₁) est reliée, par l'intermédiaire d'une impédance fonction de la fréquence (Z₈), à la borne négative de la tension continue d'alimentation.

17. Étage mélangeur selon la revendication 15 ou 16, caractérisé par le fait qu'en vue de l'alimentation en courant continu et d'une séparation d'avec le courant alternatif, l'électrode d'émetteur ou l'électrode de source du second transistor (T₂) est reliée, par l'intermédiaire d'une impédance fonction de la fréquence (Z₇), à la borne positive (+) de la tension continue d'alimentation.

18. Etage mélangeur selon la revendication 15, caractérisé par le fait qu'en vue du couplage du signal d'entrée (ES), est prévu un transformateur (Tr) comprenant 3 bobinages, que le premier bobinage (W₁) du transformateur (Tr) est relié par un pôle, à l'électrode d'émetteur du second transistor (T₂), et par l'autre pôle, à la borne positive (+) de la tension continue d'alimentation, que le second bobinage (W₂) du transformateur (Tr) est relié, par un pôle, à l'électrode d'émetteur du premier transistor (T₁) et, par l'autre pôle, à la borne négative de la tension continue d'alimentation, et que le troisième bobinage (W3) du transformateur (T₁) est relié, par un pôle, à la source du signal d'entrée (ESQ).

19. Étage mélangeur selon l'une des revendications 14 à 18, caractérisé par le fait que le signal de sortie est prélevé au point nodal de sortie (K₃) par l'intermédiaire d'une impédance fonction de la fréquence (Z₆).

20. Étage mélangeur selon l'une des revendications 14 à 19, caractérisé par le fait que, en vue de la suppression de la fréquence du signal d'entrée tension alternative (ES), les électrodes de base ou de grille des deux transistors (T₁ et T₂) sont reliées à des impédances fonctions de la fréquence (Z₃, Z₄, Z₅) et, en vue de l'alimentation en tension, elles le sont avec l'oscillateur local (LO), et chacune, avec une source de courant continu (DCQ1, DCQ2).

21. Étage mélangeur selon l'une des revendications 10 à 20, caractérisé par le fait que les impédances fonction de la fréquence, (Z₁ - Z₈) sont conçues sous forme de composants passifs ou de composants électroniquement actifs.
